# EUROPÄISCHE PATENTSCHRIFT

(11) **EP 1 568 077 B1**
(45) Veröffentlichungstag und Bekanntmachung des Hinweises auf die Patenterteilung: **11.07.2018**
(21) Anmeldenummer: 03782305.1
(22) Anmeldetag: 04.12.2003
(51) Int. Cl.: H01L 21/46, H01L 27/12, H01L 21/18

(54) **VERFAHREN ZUR VORBEHANDLUNG DER OBERFLÄCHEN VON ZU BONDENDEN SUBSTRATEN**
METHOD FOR PRE-TREATING SURFACES OF SUBSTRATES TO BE BONDED
PROCEDE DE PRETRAITEMENT DES SURFACES DE SUBSTRATS A ASSEMBLER

(30) Priorität: 04.12.2002 DE 10256693; 14.07.2003 DE 10331815; 14.08.2003 DE 10337514
(43) Veröffentlichungstag der Anmeldung: 31.08.2005
(73) Patentinhaber: Suss MicroTec Lithography GmbH, 85748 Garching (DE)
(72) Erfinder: GABRIEL, Markus, 85748 Garching (DE); OSSMANN, Christian, 81369 München (DE)
(74) Vertreter: Prinz & Partner mbB
(86) Internationale Anmeldenummer: PCT/EP2003/013710
(87) Internationale Veröffentlichungsnummer: WO 2004/051729

(56) Entgegenhaltungen:
- WO-A-01/61743
- WO-A-02/13247
- US-A- 5 560 777
- US-A1- 2002 068 419

## Beschreibung

Die Erfindung betrifft ein Verfahren und eine Vorrichtung zum Bonden (Verbinden) von Substraten und insbesondere zur Vorbehandlung der Oberflächen von Substraten vor einem Bonden der Substrate in der Halbleitertechnologie.

Die Substrate können direkt oder über Zwischenschichten miteinander verbunden werden. So können die Substrate ganz oder teilweise metallisiert sein, insbesondere mit Kupfer, und dann über die Metalloberflächen eutektisch gebondet werden.

Beim Bonden (Verbinden) von z.B. Halbleitersubstraten, wobei je eine Oberfläche der Halbleitersubstrate miteinander fest verhaftet werden, spielt die Beschaffenheit der zu verbindenden Oberflächen eine große Rolle. Die physikalische und chemische Oberflächenbeschaffenheit hat einen direkten Einfluß auf die Haftfestigkeit der zu verbindenden Substrate. So können insbesondere die Oberflächen-Rauhigkeit (makroskopisch und mikroskopisch), eventuelle Zwischen- und Grenzschichten und die Oberflächenenergie bzw. Oberflächenspannung das Bondergebnis beeinflussen. Beim Bonden der Substrate über Kupferschichten auf der Oberfläche der Substrate wirkt sich auf den Schichten gebildetes Kupferoxid nachteilig auf die Bondfestigkeit aus.

Es ist bereits bekannt, die Substratoberflächen mittels Plasma in einer Niederdruck-Plasmaanlage zu behandeln. Allerdings ist dieses Verfahren wegen der erforderlichen Niederdruck-Plasmaanlage apparativ aufwendig und wegen der Ein-/Ausschleusung der Substrate auch zeitaufwendig. Außerdem ist zur Erhöhung der Verbindungsenergie eine Temperaturbehandlung bei ca. 400°C erforderlich.

Aus "Vakuum in Forschung und Praxis" 14 (2002), Nr. 3, Seiten 149-155 ist es an sich bekannt, Oberflächen von Festkörpern mittels Plasma bei Atmosphärendruck zu reinigen und zu beschichten. Die Druckschrift gibt eine Übersicht über entsprechende Beschichtungssysteme und Reinigungsverfahren. Außerdem wird der operative Aufbau einer Vorrichtung zur Beschichtung und Reinigung von Oberflächen mittels Atmosphärendruckplasmen dargestellt. Dabei werden mittels atmosphärischen Plasma, z.B. die Oberflächen von Metallen behandelt, um einen Korrosionsschutz zu erreichen, und die Oberfläche von Kunstoffen vor einer organischen Beschichtung modifiziert.

Die WO 02/13247 A1 beschreibt ein Verfahren zum Bonden oxidfreier Siliziumsubstratpaare und anderer Substrate bei niedriger Temperatur, wobei das Verfahren das Modifizieren der Oberfläche der Siliziumwafer zur Erzeugung von Defektregionen aufweist.

In der WO 01/61743 A1 wird ein Verfahren zum Verbinden bei niedriger oder Raumtemperatur offenbart, das Verfahrensschritte zum Reinigen und Aktivieren der Oberfläche durch Reinigen oder Ätzen aufweist.

In der US 2002/0068419 A1 wird ein Halbleiterartikel und ein Verfahren zum Herstellen dieses Artikels offenbart.

Die US 5, 560, 777 A beschreibt eine Vorrichtung zum Herstellen eines Halbleiters bei Atmosphärendruck, der eine erste Elektrode und eine zweite Elektrode aufweist, die zum Empfangen einer HF-Spannung angepasst sind, um eine Koronaentladung durchzuführen.

Der Erfindung liegt die Aufgabe zugrunde, ein einfaches und kostengünstiges Verfahren zur Verfügung zu stellen, mit dem die Haftfestigkeit der gebondeten Substrate verbessert wird und die Temperatur der Wärmebehandlung zur Erhöhung der Verbindungsenergie (Bondenergie) gesenkt wird.

Die Aufgabe wird mit den Merkmalen der Patentansprüche gelöst.

Bei der Lösung geht die Erfindung von folgenden Grundgedanken aus.

Nachstehend wird eine Oberfläche oder eine Schicht auf der Oberfläche eines Substrates, über die dieses Substrat mit einem anderen Substrat verbunden (gebondet) werden soll, als "Bondfläche" bezeichnet.

Vor dem Bonden wird mindestens eine der Bondflächen der zu verbindenden Halbleitersubstrate der Einwirkung eines atmosphärischen Plasmas ausgesetzt. In einer bevorzugten Ausführungsform wird das Plasma, das durch ein entsprechendes Gas gebildet wird, durch eine Koronaentladung erzeugt. In Abhängigkeit von der Verweildauer der Bondfläche im Plasma, der Energiedichte sowie der angelegten Spannung und Frequenz kann durch die Plasmabehandlung die Bondfläche gereinigt, chemisch aktiviert oder abgetragen werden, wobei auch unerwünschte Zwischenschichten wie Oxide auf Metallschichten entfernt werden und sich auch eine Glättung, d.h. die Beseitigung von Rauhigkeiten der Oberfläche ergibt. Wenn durch das Plasma eine Schicht auf der Oberfläche aufgetragen werden soll, wird das das Plasma bildende Gas so gewählt, daß es mit der Substratoberfläche reagiert, z.B. Sauerstoff zur Bildung von Isolatorschichten aus SiOₓ. Die erfindungsgemäße Plasmabehandlung kann sowohl vor als auch nach naßchemischen Reinigungsverfahren erfolgen und als letzter Prozeßschnitt vor dem Bonden der Substrate vorgesehen werden. Eine Vorrichtung zur Plasmabehandlung vor dem Bonden, die der im Stand der Technik bekannten Vorrichtung entsprechen kann, kann in einer Einheit mit einer Vorrichtung für Naßchemiebehandlung, wie sie in der PCT/EP01/07042 beschrieben und dort in der zugehörigen Fig. 1 gezeigt ist, und einer Vorrichtung zum Bonden von Substraten zusammengefaßt sein. Die Vorrichtung kann jedoch auch räumlich getrennt von den Vorrichtungen für naßchemische Behandlung und das Bonden von Substraten angeordnet sein.

Die Vorrichtung zur Plasmabehandlung kann so gestaltet sein, dass ein oder mehrere Substrate auf einer Ebene liegend behandelt werden. Sie kann aber auch so gestaltet werden, dass zwei oder mehrere Substrate in parallerer Anordnung mit dem gleichen Elektrodensystem synchron behandelt werden. Die zweite Ausführung ist insbesondere in einer Anlage vorzuzuiehen, die aus der Kombination von Vorrichtungen zur Plasmabehandlung und anschliessendem Bonden besteht. Die Vorteile liegen darin, dass die Substrate unmittelbar nach der Behandlung gebondet werden können und die Gesamtprozesszeit weiter verkürzt werden kann. Der Substrattransport von einer Vorrichtung zur anderen entfällt und das Risiko die Substrate dabei zu kontaminieren wird minimiert.

Der Vorteil der Erfindung liegt in einer einfachen und kostengünstigen Behandlung vor dem Bonden, wobei eine Erwärmung der Substrate und die Schädigung von temperaturempfindlichen Substraten vermieden wird. Bei der erfindungsgemäß bevorzugten Plasmaerzeugung durch Koronaentladung (dielektrische Barrierenentladung) bildet sich zwischen zwei leitenden Elektroden beim Anlegen einer Wechselspannung hinreichender Größe eine Vielzahl lokalisierter Mikroentladungen aus, die eine sehr kurze Zeitdauer im Bereich von 10⁻⁸ sec haben. Bei diesen Mikroentladungen werden Gase durch elektronische Anregung, Ionisation und Dissoziation aktiviert und chemisch reaktive Spezies gebildet. Dabei wird die mittlere Gastemperatur im Entladungsspalt um wenige Grad Kelvin erhöht. Die Entladung bleibt also kalt und ist daher für das Bonden von Halbleitersubstraten sehr gut geeignet. Besonders vorteilhaft ist die Erfindung für das Direktverbinden (direct bonding) von Substraten, da dabei sehr saubere und glatte Oberflächen benötigt werden. Durch die Erfindung kann die Oberflächenenergie bzw. -spannung erhöht werden. Dadurch kann bei dem erforderlichen Ausheilen (Annealing) bei gleicher Bondfestigkeit mit deutlich geringeren Temperaturen ausgekommen werden. Bei diesem Ausheilen werden die relativ schwachen Van-der-Waals Bindungen in kovalente (chemische) Bindungen umgewandelt.

Im folgenden wird die Erfindung anhand der Zeichnung näher erläutert. Es zeigen:
- Fig. 1: ein allgemeines Prinzipbild einer Plasmabehandlung der Oberfläche eines Halbleitersubstrats,
- Fig. 2: das Prinzipbild einer Vorrichtung zur Vorbehandlung von Bondflächen, die in der Erfindung eingesetzt werden kann,
- Fig. 3: das Prinzipbild einer Vorrichtung zur simultanen Vorbehandlung von Bondflächen in zwei parallelen Ebenen, die in der Erfindung eingesetzt werden kann,
- Fig. 4: den Effekt verschiedener Plasmagase auf die Erhöhung der Verbindungsenergie, und
- Fig. 5: den Effekt des Gasflusses auf die Erhöhung der Verbindungsenergie.

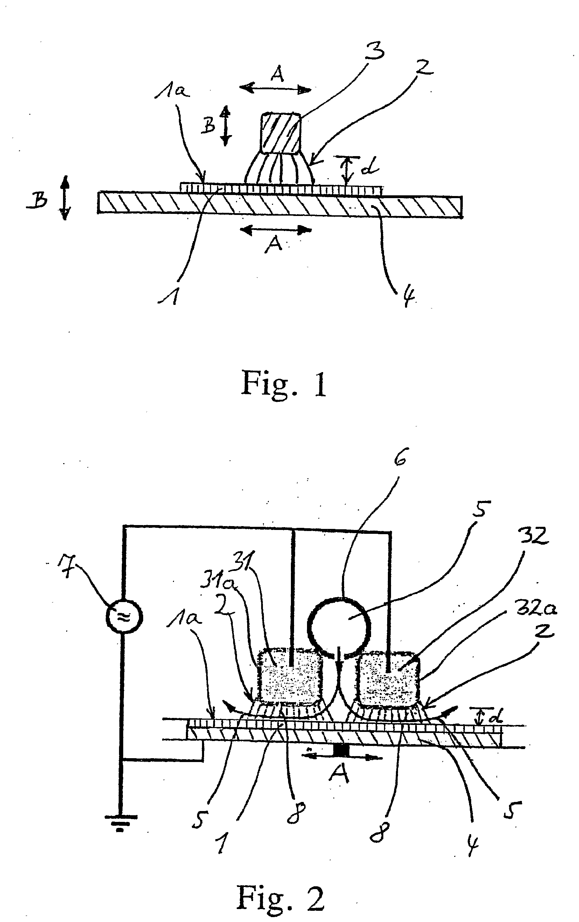

Figur 1 zeigt einen Querschnitt durch ein Halbleitersubstrat 1 auf einem Träger 4, auf das ein Plasma 2 einwirkt. Das Plasma 2 wird unterhalb einer Hochspannungselektrode 3 aus einem Prozeßgas erzeugt. Der Träger 4 für das Halbeitersubstrat dient als Gegenelektrode. Es ist auch möglich, einen Aufbau ohne Gegenelektrode zu verwenden. In diesem Fall kann das zu behandelnde Substrat elektrisch isoliert werden. Dies wird auch als "floated plasma" bezeichnet. Die Plasmaeinwirkung auf die Oberfläche 1a des Halbleitersubstrats 1 kann durch Bewegung der Gegenelektrode 3 in horizontaler Richtung als auch durch Bewegung des Trägers 4 in horizontaler Richtung gegenüber dem Plasma 2 erfolgen. Möglich ist aber auch eine gleichzeitige Bewegung des Plasmas und des Trägers 4 mit dem Halbleitersubstrat in entgegengesetzte Richtungen. Diese Bewegungen werden durch die Doppelpfeile A angezeigt. Der Abstand d zwischen der Halbleitersubstratoberfläche 1a und der Hochspannungselektrode 3 kann durch Bewegung der Hochspannungselektrode 3 oder des Trägers 4 in Doppelpfeilrichtung B eingestellt werden. Es wurde gefunden, daß ein Durchlauf (Scan) des Plasmas über die Oberfläche 1a des Halbleitersubstrats ausreichend ist. Mit der Anzahl der Scans nimmt die Bondenergie wieder ab. Das bedeutet, daß durch die Plasmabehandlung eine Modifizierung der Oberfläche erreicht wird.

Figur 2 zeigt eine Realisierung des in Figur 1 dargestellten Prinzips mittels einer dielektrischen Barrierenentladung in Luft, wie sie bei der Erfindung zum Einsatz kommen kann. In Figur 2 ist gegenüber der Oberfläche 1a des Halbleitersubstrats 1, das sich auf dem Träger 4 befindet, eine zweiteilige Hochspannungselektrode 31, 32 mit einer dielektrischen Barrierenschicht 31a bzw. 32a angeordnet; diese Elektroden 31, 32 sind an einen Hochspannungsgenerator 7 angeschlossen. Der Träger 4 ist als Gegenelektrode mit Erde verbunden. Zwischen den Hochspannungselektroden 31, 32 und der Oberfläche 1a des Halbleitersubstrats erfolgt eine Mikroentladung 8, die aus einem Prozeßgas 5, das aus einem . Prozeßgasbehälter 6 durch das elektrische Feld zwischen den Hochspannungselektroden 31, 32 und der Oberfläche 1a fließt, ein Plasma 2 erzeugt. Das Plasma wird durch Mikroentladungen mit einer Dauer von 1-10 ns gebildet. Die Entladungswege haben einen Radius von 0,1 mm. Die während einer Mikroentladung transportierte Ladung beträgt 100 bis 1000 pC. Die Stromdichte beträgt 100 bis 1000 A/cm². Die Elektronendichte ist 10¹⁴ bis 10¹⁵ cm⁻³ und die durchschnittliche Elektronenenergie beträgt 1 bis 10 eV. Während der Plasmabehandlung wird der Gasfluß aufrechterhalten, um eine Verdünnung des Prozeßgases durch Einfließen von Luft aus der Umgebung zu verhindern. Vorzugsweise wird der Abstand d zwischen den Hochspannungselektroden 31, 32 und der Halbleitersubstratoberfläche 1a auf etwa 0,5 bis 2 mm eingestellt. Die Elektrodenspannung beträgt vorzugsweise 10 bis 20 kV und die Frequenz wird vorzugsweise von 20 bis 60 kH eingestellt. Das Plasma kann jedoch auch mit höheren Frequenzen bis zu etwa 14 MHz angeregt werden. Als Prozeßgase können O₂ oder O₃ verwendet werden, wenn z.B. die Oberfläche 1a gereinigt oder mit einer Isolatorschicht bedeckt werden soll. Für den Schichtabtrag, der Rauhigkeiten beseitigen und Oberflächenatome chemisch aktivieren soll, ist eine Plasmabehandlung mit einem Inertgas z.B. Stickstoff oder Argon, vorteilhaft. Als Prozeßgase können weiterhin CO₂, NH₃, Formiergas, HCl oder Gemische der genannten Gase verwendet werden.

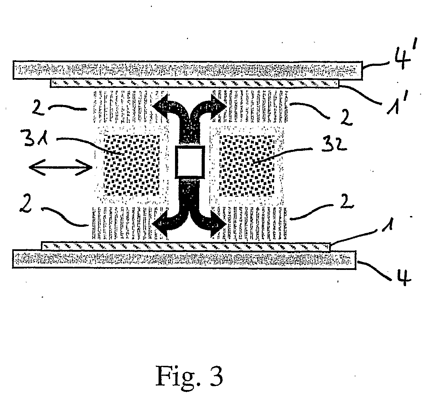

In Figur 3 ist eine alternative Realisierung des in Figur 1 gezeigten Prinzips dargestellt, wobei zwei Halbleitersubstrate 1, 1' parallel zueinander auf Trägern 4, 4' angeordnet sind. Die beiden Halbleitersubstrate 1, 1' können so synchron mit dem gleichen Elektrodensystem 31, 32 behandelt werden.

Es wurde gefunden, daß mit dem erfindungsgemäßen Verfahren bei der erforderlichen Ausheilung nach dem Bonden bereits bei einer Ausheiltemperatur von 200°C ausreichende Verbindungsenergien von σ ≥ 2 J/m² erreicht werden. Dieser Wert ergibt sich bereits bei niedrigen Ausheilzeiten von 1-5 Stunden.

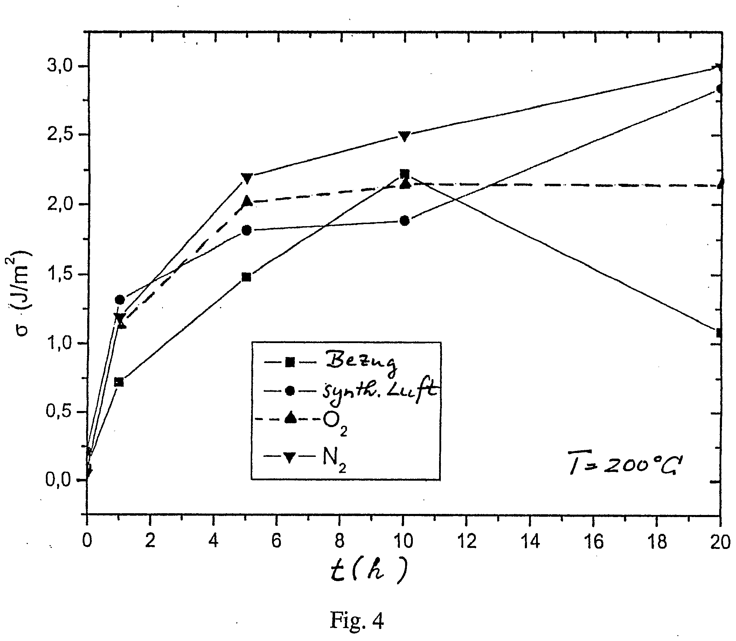

In Figur 4 wird die Wirkung verschiedener Plasmagase auf die Verbindungsenergie σ in Abhängigkeit der Ausheilzeit t bei 200°C und nach einem Scan dargestellt. Untersucht wird synthetische Luft, reiner Sauerstoff und reiner Stickstoff. Als Bezug wird normale Luft angegeben. Es ist zu erkennen, daß bei einem Plasma aus reinem Stickstoff die höchsten Bindungsenergien in der kürzesten Zeit erreicht werden.

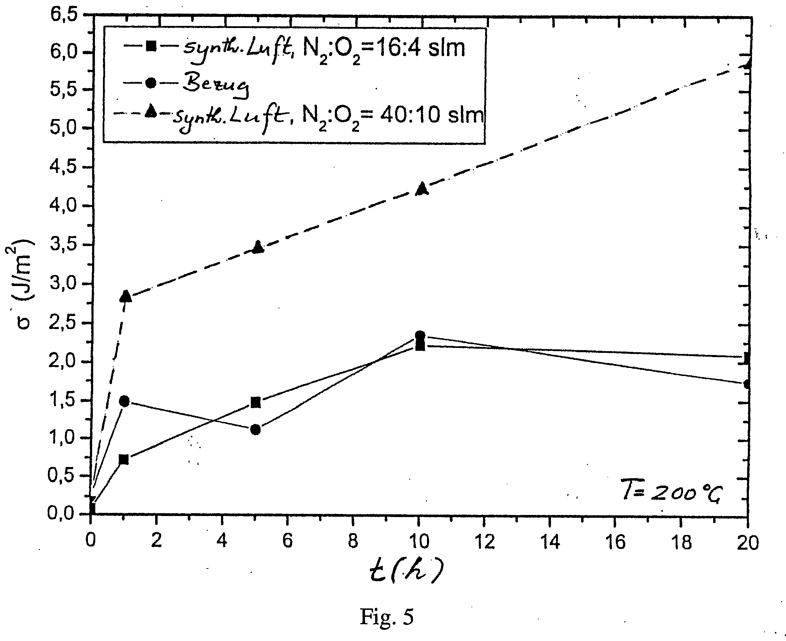

Figur 5 zeigt den Einfluß des Gasflusses auf die Erhöhung der Bindungsenergie σ in Abhängigkeit der Ausheilzeit t bei 200°C nach einem Scan. Untersucht wurde synthetische Luft mit einer Zusammensetzung aus Stickstoff und Sauerstoff und normale Luft als Bezug. Die Gasflüsse von Stickstoff und Sauerstoff standen in einem Verhältnis von 16 zu 4 slm (Liter pro Minute bei 20°C und einer Atmosphäre) bzw. 40 zu 10 slm. Es ist zu erkennen, daß die Erhöhung des Gasflusses zu den besten Bindungsenergien in der kürzesten Zeit führt. Der Gasfluß ist also von entscheidender Bedeutung für das erfindungsgemäße Verfahren. Hohe Gasflüsse erhöhen wesentlich die Bondenergie.

Durch die erfindungsgemäße Plasmabehandlung wird auch die Entstehung von Grenzflächendefekten (Bläschen) verhindert Nach der Behandlung mit einem Plasma aus reinem Stickstoff oder synthetischer Luft wurden auch nach einer Ausheilung von 20 Stunden bei 200°C IR-mikroskopisch keine erkennbaren Defekte festgestellt. Jedoch wurden bei gleicher Wärmebehandlung nach Behandlung mit einem Sauerstoffplasma noch Defekte festgestellt. Generell steigt bei höheren Temperaturen einer Wärmebehandlung die Wahrscheinlichkeit der Erzeugung von Grenzflächendefekten. Da jedoch das erfindungsgemäße Verfahren nur kurze Wärmebehandlungszeiten zum Erreichen einer hohen Grenzflächenenergie erfordert, sind bei dem erfindungsgemäßen Verfahren Grenzflächendefekte unkritisch.

Die Plasmabehandlungsvorrichtung gemäß Figur 2 wird mit einer vorzugsweise direkt nachgeschalteten Vorrichtung zum Bonden der Halbleitersubstrate kombiniert. Das Bonden der Substrate erfolgt bevorzugt durch Direktverbinden (d.h. ohne Zwischenschicht). Es kann aber auch nach einer Reaktion des Plasmas mit der Oberfläche des Halbleitersubstrats eine Zwischenschicht aufgewachsen werden, wobei das Bonden z.B. mittels eines Klebers erfolgt. Weiterhin können Oberflächen von Substraten behandelt werden, die bereits eine Kleber-, Lot- oder Metallschicht aufweisen. Das geschieht z.B. zum Reinigen, Abtragen von nativen Oxiden oder zur Aktivierung der Schichten. Das Bonden der Substrate kann auch über teilweise oder vollständig auf den Substraten aufgebrachte Metallschichten, vorzugsweise Kupfer erfolgen. Die Substrate werden dann eutektisch gebondet. Es wurde gefunden, daß das erfindungsgemäße Plasma unter Atmosphärendruck (AP) Kupferoxid, das sich auf Kupferoberflächen an normaler Luft schnell bildet, von der Oberfläche der Kupferschicht auf dem Substrat entfernt. Dadurch erhöht sich die Bondfestigkeit beim nachfolgenden Bonden.

Vorzugsweise kommt die Erfindung beim SOI (Silicon On Insulator) -Bonding zum Einstz.

Die Plasmabehandlungsvorrichtung kann sich in Prozeßrichtung hinter einer Vorrichtung für die naßchemische Behandlung der Substrate befinden. Es können auch mehrere aufeinanderfolgende Vorrichtungen für die naßchemische und die Plasmabehandlung vorgesehen sein, wobei die Reihenfolge der Vorrichtungen austauschbar ist. Die Vorrichtung zur Plasmabehandlung kann mit einer Vorrichtung zur naßchemischen Behandlung und einer Vorrichtung zum Bonden in einer integralen Einheit zusammengefasst sein. Die genannten Vorrichtungen können jedoch auch räumlich getrennt voneinander innerhalb einer entsprechenden Zusammenfassung (Bondcluster) angeordnet sein. Bevorzugt werden mit der Vorrichtung Substrate mit einem Durchmesser von 300 mm plasmabehandelt.

Die vielseitige Anordnung der Plasmabehandlungsvorrichtung ergibt sich daraus, daß das Plasma bei Atmosphärendruck erzeugt und aufrechterhalten wird und somit auf eine Vakuumapparatur verzichtet werden kann. Damit ist ein flexibler Einsatz des erfindungsgemäßen Verfahrens möglich, wobei Produktionskosten und -zeiten eingespart werden können.

## Patentansprüche

1. Verfahren zum Verbinden von mindestens zwei Substraten (1, 1') durch Bonden nach einer Vorbehandlung mindestens einer der Bondflächen, **dadurch gekennzeichnet dass** zur Vorbehandlung auf die Bondfläche ein Plasma (2) bei Atmosphärendruck einwirkt, wobei das Plasma (2) durch eine dielektrische Barnierenentlandung (8) erzeugt wird.

2. Verfahren nach Anspruch 1, wobei die Bondfläche (1a) durch das Plasma (2) gereinigt wird.

3. Verfahren nach einem der Ansprüche 1 oder 2, wobei die Bondfläche (1a) durch das Plasma (2) chemisch aktiviert wird.

4. Verfahren nach einem der Ansprüche 1 bis 3, wobei durch das Plasma (2) eine Schicht der Bondfläche (1a) abgetragen wird.

5. Verfahren nach einem der Ansprüche 1 bis 4, wobei durch das Plasma (2) eine Schicht auf die Bondfläche (1a) aufgewachsen wird.

6. Verfahren nach einem der Ansprüche 1 bis 4, wobei die Substrate (1, 1') beim Bonden direkt miteinander verbunden werden.

7. Verfahren nach einem der Ansprüche 1 bis 4, wobei die Substrate (1, 1') über Metallschichten, die die Substrate ganz oder teilweise bedecken, miteinander verbunden werden.

8. Verfahren nach Anspruch 7, wobei die Metallschichten aus Kupfer bestehen.

9. Verfahren nach einem der Ansprüche 1 bis 8, wobei die Plasmabehandlung vor einer naßchemischen Reinigung der Substrate (1, 1') erfolgt.

10. Verfahren nach einem der Ansprüche 1 bis 8, wobei die Plasmabehandlung nach einer naßchemischen Reinigung der Substrate (1, 1') erfolgt.

11. Verfahren nach einem der Ansprüche 1 bis 10, wobei die Plasmabehandlung als letzter Prozeßschritt vor dem Bonden erfolgt.

12. Verfahren nach einem der Ansprüche 9 bis 11, wobei die Plasmabehandlung und die naßchemische Reinigung mehrfach erfolgen.

13. Verfahren nach einem der Ansprüche 1 bis 12, wobei das Plasma (2) unter Verwendung von O₂- oder O₃-Gas oder Inertgasen erzeugt wird.

14. Verfahren nach Anspruch 13, wobei das Plasma (2) unter Verwendung von N₂-Gas erzeugt wird.

15. Verfahren nach einem der Ansprüche 1 bis 14, wobei als Prozeßgas CO₂, NH₃, Formiergas oder HCl, oder Gasgemische hiervon verwendet werden.

16. Verfahren nach einem der Ansprüche 1 bis 15, wobei das Plasma (2) über die Bondfläche (1a) des Substrats (1, 1') bewegt wird.

17. Verfahren nach einem der Ansprüche 1 bis 15, wobei die Bondfläche (1a) des Substrats (1, 1') durch das Plasma (2) bewegt wird.

18. Verfahren nach einem der Ansprüche 1 bis 15, wobei das Plasma (2) und die Bondfläche (1a) des Substrats (1, 1') gegeneinander bewegt werden.

19. Verfahren nach einem der Ansprüche 16 bis 18, wobei nur ein Durchlauf des Plasmas (2) über die Bondfläche (1a) erfolgt.

20. Verfahren nach einem der Ansprüche 1 bis 19, wobei das Plasma (2) gleichzeitig auf die Bondflächen (1a) mehrerer Substrate (1, 1') einwirkt.

21. Verfahren nach einem der Ansprüche 1 bis 20 zur Vorbehandlung beim Bonden von Halbleitersubstraten oder beim SOI-Bonden.

## Revendications

1. Procédé de raccordement d'au moins deux substrats (1, 1') par assemblage après un prétraitement d'au moins l'une des surfaces d'assemblage, **caracterisé en ce qu'**un plasma (2) agit sur la surface d'assemblage à une pression atmosphérique pour le prétraitement, le plasma (2) étant produit par une décharge de barrière diélectrique (8).

2. Procédé selon la revendication 1, la surface d'assemblage (1a) étant nettoyée par le plasma (2).

3. Procédé selon l'une des revendications 1 ou 2, la surface d'assemblage (1a) étant activée chimiquement par le plasma (2).

4. Procédé selon l'une des revendications 1 à 3, une couche de la surface d'assemblage (1a) étant enlevée par le plasma (2).

5. Procédé selon l'une des revendications 1 à 4, une couche étant formée par croissance sur la surface d'assemblage (1a) par le plasma (2).

6. Procédé selon l'une des revendications 1 à 4, les substrats (1, 1') étant directement reliés l'un à l'autre lors de l'assemblage.

7. Procédé selon l'une des revendications 1 à 4, les substrats (1, 1') étant reliés l'un à l'autre par des couches métalliques qui recouvrent entièrement ou partiellement les substrats.

8. Procédé selon la revendication 7, les couches métalliques étant en cuivre.

9. Procédé selon l'une des revendications 1 à 8, le traitement au plasma étant effectué avant un nettoyage chimique par voie humide des substrats (1, 1').

10. Procédé selon l'une des revendications 1 à 8, le traitement au plasma étant effectué après un nettoyage chimique par voie humide des substrats (1, 1').

11. Procédé selon l'une des revendications 1 à 10, le traitement au plasma étant effectué en tant que dernière étape de processus avant l'assemblage.

12. Procédé selon l'une des revendications 9 à 11, le traitement au plasma et le nettoyage chimique par voie humide étant effectués à plusieurs reprises.

13. Procédé selon l'une des revendications 1 à 12, le plasma (2) étant produit en utilisant un gaz O₂ ou O₃ ou des gaz inertes.

14. Procédé selon la revendication 13, le plasma (2) étant produit en utilisant du gaz N₂.

15. Procédé selon l'une des revendications 1 à 14, du CO₂, du NH₃, du gaz de formation ou du HCl ou des mélanges gazeux de ceux-ci étant utilisés en tant que gaz de processus.

16. Procédé selon l'une des revendications 1 à 15, le plasma (2) etant déplacé sur la surface d'assemblage (1a) du substrat (1, 1').

17. Procédé selon l'une des revendications 1 à 15, la surface d'assemblage (1a) du substrat (1, 1') étant déplacée à travers le plasma (2).

18. Procédé selon l'une des revendications 1 à 15, le plasma (2) et la surface d'assemblage (1a) du substrat (1, 1') étant déplacés l'un par rapport à l'autre.

19. Procédé selon l'une des revendications 16 à 18, un seul passage du plasma (2) sur la surface d'assemblage (1a) étant effectué.

20. Procédé selon l'une des revendications 1 à 19, le plasma (2) agissant simultanément sur les surfaces d'assemblage (1a) de plusieurs substrats (1, 1').

21. Procédé selon l'une des revendications 1 à 20 pour le prétraitement lors de l'assemblage de substrats semi-conducteurs ou de l'assemblage SOI.

## Claims

1. Method for joining at least two substrates (1, 1') by bonding after a pretreatment of at least one of the bonding surfaces, **characterised in that** for the pretreatment a plasma (2) acts on the bonding surface under atmospheric pressure, wherein the plasma (2) is generated by a dielectric barrier discharge.

2. Method according to claim 1, wherein the bonding surface (1a) is cleaned by the plasma (2).

3. Method according to one of claims 1 or 2, wherein the bonding surface (1a) is chemically activated by the plasma (2).

4. Method according to one of claims 1 to 3, wherein a layer of the bonding surface (1a) is stripped off by the plasma (2).

5. Method according to one of claims 1 to 4, wherein a layer is grown on the bonding surface (1a) by the plasma (2).

6. Method according to one of claims 1 to 4, wherein the substrates (1, 1') are joined directly to one another during the bonding.

7. Method according to one of claims 1 to 4, wherein the substrates (1, 1') are joined to one another via metal layers which completely or partially cover the substrates.

8. Method according to claim 7, wherein the metal layers consist of copper.

9. Method according to one of claims 1 to 8, wherein the plasma treatment is carried out before a wet chemical cleaning of the substrates (1, 1').

10. Method according to one of claims 1 to 8, wherein the plasma treatment is carried out after a wet chemical cleaning of the substrates (1, 1').

11. Method according to one of claims 1 to 10, wherein the plasma treatment is carried out as the last process step before the bonding.

12. Method according to one of claims 9 to 11, wherein the plasma treatment and the wet chemical cleaning are carried out several times.

13. Method according to one of claims 1 to 12, wherein the plasma (2) is generated using O2 or O3 gas or inert gases.

14. Method according to claim 13, wherein the plasma (2) is generated using N₂ gas.

15. Method according to one of claims 1 to 14, wherein CO₂, NH₃, forming gas or HCl or gas mixtures thereof are used as the process gas.

16. Method according to one of claims 1 to 15, wherein the plasma (2) is moved over the bonding surface (1a) of the substrate (1, 1').

17. Method according to one of claims 1 to 15, wherein the bonding surface (1a) of the substrate (1, 1') is moved through the plasma.

18. Method according to one of claims 1 to 15, wherein the plasma (2) and the bonding surface (1a) of the substrate (1, 1') are moved relative to one another.

19. Method according to one of claims 16 to 18, wherein only a flow-through of the plasma (2) over the bonding surface (1a) is carried out.

20. Method according to one of claims 1 to 19, wherein the plasma (2) acts simultaneously on the bonding surfaces (1a) of several substrates (1, 1').

21. Method according to one of claims 1 to 20 for pretreatment in the bonding of semiconductor substrates or in SOI bonding.
